Europäisches Patentamt

European Patent Office

Office européen des brevets

(19)

(11) Veröffentlichungsnummer: **0 364 688**

**A1**

(12) **EUROPÄISCHE PATENTANMELDUNG**

(21) Anmeldenummer: 89115065.8

(22) Anmeldetag: 16.08.89

(51) Int. Cl.5: **C23C 18/16 , C25D 5/02 , C25F 3/14**

(30) Priorität: 26.09.88 DE 3832957

(43) Veröffentlichungstag der Anmeldung:
25.04.90 Patentblatt 90/17

(84) Benannte Vertragsstaaten:
BE CH DE ES FR GB IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Heydecke, Jens
Letteallee 90
D-1000 Berlin 51(DE)
Erfinder: Bläsing, Horst
Strünckweg 1
D-1000 Berlin 13(DE)

(54) Verfahren zur Herstellung von metallstrukturierten Folien und Vorrichtung dafür.

(57) Die Erfindung betrifft ein Verfahren zur Herstellung von metallstrukturierten Folien, insbesondere Flachbandleiter, Flexschaltungen und Heizfolien, durch chemische und galvanische Metallisierung von Nichtleitern in Form von Folien in kontinuierlichem Durchlauf, gekennzeichnet durch folgende Verfahrensschritte:
- Beidseitige chemische Metallisierung der kontinuierlich laufenden Folien
- Abdecken der nicht zu metallisierenden, aktivierten Oberflächen
- Elektrolytische Entfernung der Metallschichten
    a) im Randbereich der Folienrückseite sowie auf den nicht galvanisch zu verstärkenden Flächen auf der Folienvorderseite (Funktionsseite) oder
    b) beidseitig - Kathodische Polarisierung der Folienseite (Funktionsseite) mittels einer stromführenden Walze und gleichzeitiges Durchlaufen eines galvanischen Metallisierungsbades, wobei chemische Rücklösung der Metallschichten auf der Folienrückseite sowie galvanische Verstärklung der chemisch metallisierten Flächen auf der freien Vorderseite (Funktionsseite) oder beidseitig erfolgt.

EP 0 364 688 A1

# VERFAHREN ZUR HERSTELUNG VON METALLSTRUKTURIERTEN FOLIEN UND VORRICHTUNG DAFüR

Die Erfindung betrifft ein Verfahren zur Herstellung von metallstrukturierten Folien, insbesondere Flachbandleitern Flexschaltungen und Heizfolien, durch chemische und galvanische Metallisierung von Nichtleitern in Form von Folien in kontinuierlichem Durchlauf sowie eine Vorrichtung hierfür.

Derartige metallstrukturierten Folien finden insbesondere Anwendung als sogenannte Flachbandleiter für flexible Verbindungen von Leiterplatten und Steuerungsteilen in der Elektrotechnik, die nach dem bekannten Stand der Technik nur durch diskontinuierliche Laminierung von Bandleitungen, Flexschaltungen und Heizfolien in relativ aufwendiger Weise hergestellt werden können.

Aufgabe der vorliegenden Erfindung ist die Bereitstellung eines Verfahrens, welches eine neuartige kontinuierliche Herstellung von metallstrukturierten Folien, insbesondere Flachbandleitern, Flexschaltungen und Heizfolien in technisch einfacher Weise ermöglicht.

Diese Aufgabe wird erfindungsgemäß durch ein Verfahren gemäß dem kennzeichnenden Teil des Patentanspruchs gelöst.

Weitere Ausgestaltungen der Erfindung sind den Kennzeichnungsteilen der Unteransprüche zu entnehmen.

Gegenstand der Erfindung ist außerdem eine Vorrichtung zur Durchführung des erfindungsgemäßen Verfahrens.

Das erfindungsgemäße Verfahren ermöglicht in bisher nicht erreichter Weise die Herstellung von metallstrukturierten Folien in kontinuierlichem Durchlauf.

Als derartige Folien von Nichtleitern sind zum Beispiel zu nennen solche aus Polyimid, Polyamide, Polyetherimide und -sulfone, Polyparaphenylensulfid, Polyester sowie Fluorpolymere, wie zum Beispiel Polytetrafluorethylen.

In der Figur sind die Verfahrensschritte und die hierfür erforderliche Vorrichtung im einzelnen dargestellt.

Hierin bedeuten:

A Folienvorderseite (Pi = Polyimid; Ch-Cu = chemisch Kupfer; G-Cu = galvanisch Kupfer)

B Folienrückseite

    1. Gefäß zur chemischen Metallisierung

    2. Anordnung zur elektrolytischen Entfernung des Metalls mittels formstabiler Flüssigkeitsträger (Tampon)

    3. Gefäß zur galvanischen Metallisierung und chemischen Rücklösung

    4. Kontaktwalzen zur kathodischen Polarisierung

Die folgenden Beispiele dienen zur Erläuterung des erfindungsgemäßen Verfahrens.

## BEISPIEL 1

Eine Polyimidfolie durchläuft ein an sich bekanntes Oberflächenbehandlungsverfahren für Nichtleiter in Form von Folien einschließlich chemischer Verkupferung mit einer Schichtdicke von ca. 0,04 µm.

Nach dem Spülprozeß wird die Folie oberflächengetrocknet.

Anschließend wird die Kupferschicht im Randbereich der Folienrückseite elektrolytisch entfernt.

Für diesen Zweck werden säurebeständige Faserschreiber verwendet, die mit ca. 10% $H_2SO_4$ gefüllt sind.

Die Streifenbreite ist abhängig von der Breite der Faserstiftspitze. Die Stifte werden mit einer Gleichstromquelle in einen Stromkreis mit der Folienrückseite geschaltet. Dabei ist die Folie anodisch, die Stifte sind kathodisch geschaltet.

Reaktion an der Faserstiftspitze:
$$Cu^o + H_2SO_4 \rightarrow CuSO_4 + H_2$$

Die notwendige Spannung liegt zwischen 0,1 und 24 V, abhängig von der Art der Stifte und den elektrischen Anschlüssen.

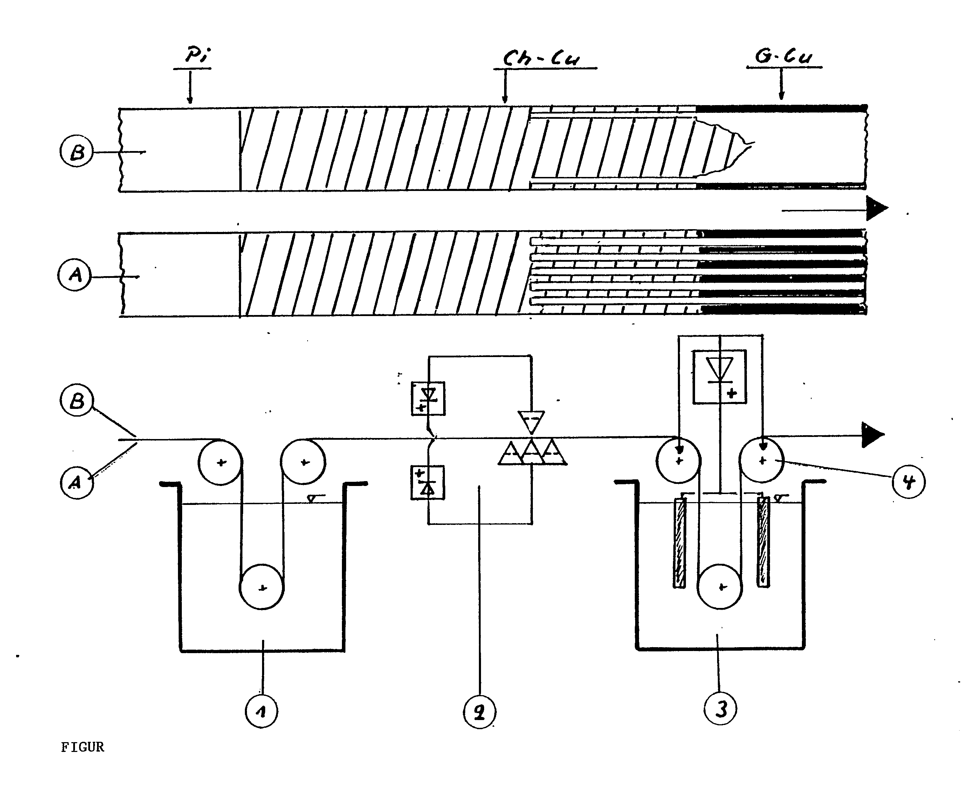

Die so behandelte Folie läuft nun in ein Galvanisiermodul ein, wo sie auf der Funktionsseite durch die erste stromführende Walze kathodisch polarisiert wird. Der Strom von der Kontaktwalze zum verbleibenden Mittelstreifen auf der Folienrückseite muß nun den Weg bis vor die Ätzstifte nehmen (siehe Figur 2). Durch den relativ hohen Widerstand der 0,04 m dicken Kupferschicht fällt die Spannung auf ca. 0,2 V ab, gemessen am Eintritt in das Galvanisiermodul.

Der Spannungsabfall ist daher eine Funktion der Folie, Schichtdicke und der elektrischen Eigenschaften der Kupferschicht zwischen Streifenätzeinrichtung und Badoberfläche des Galvanisiermoduls. 1 µm ist ausreichend, um eine Rücklösung der Kupferschicht auf der Folienrückseite zu erreichen.

Dieses elektrische Potential reicht nicht aus, um die Kupferschicht auf der Rückseite galvanisch zu verstärken. Aufgrund dessen löst sich der Mittelstreifen im sauren Kupferbad auf.

Für die Herstellung von Flachbandleitern werden zusätzlich noch Streifen auf der Funktionsseite nach dem gleichen elektrolytisdchen Rücklösungsverfahren erzeugt.

## BEISPIEL 2

Die aktivierte Folie wird an der nicht zu metallisierenden Fläche beschichtet (Loch usw.). Die nicht geschützten Flächen werden nach den beschriebenen Verfahren chemisch und galvanisch beschichtet unter Ausbildung einer metallstrukturierten Folie.

**Ansprüche**

1. Verfahren zur Herstellung von metallstrukturierten Folien, insbesondere Flachbandleitern, Flexschaltungen und Heizfolien, durch chemische und galvanische Metallisierung von Nichtleitern in Form von Folien in kontinuierlichem Durchlauf, gekennzeichnet durch folgende Verfahrensschritte:
- Beidseitige chemische Metallisierung der kontinuierlich laufenden Folien
- Abdecken der nicht zu metallisierenden, aktivierten Oberflächen
- Elektrolytische Entfernung der Metallschichten
a) im Randbereich der Folienrückseite sowie auf den nicht galvanisch zu verstärkenden Flächen auf der Folienvorderseite (Funktionsseite) oder
b) beidseitig
- Kathodische Polarisierung der Folienseite (Funktionsseite) mittels einer stromführenden Walze und gleichzeitiges Durchlaufen eines galvanischen Metallisierungsbades, wobei chemische Rücklösung der Metallschichten auf der Folienrückseite sowie galvanische Verstärkung der chemisch metallisierten Flächen auf der freien Vorderseite (Funktionsseite) oder beidseitig erfolgt.

2. Verfahren gemäß Anspruch 1 dadurch gekennzeichnet, daß die elektrolytische Entfernung der Metallschicht unter Verwendung elektrolytresistenter Flüssigträger, vorzugsweise gefüllt mit Säuren oder Laugen, erfolgt.

3. Verfahren gemäß Anspruch 2, dadurch gekennzeichnet, daß die Flüssigkeitsträger mit einer Gleichstromquelle in einem Stromkreis mit der Folienrückseite geschaltet sind, wobei die Folien anodisch und die Flüssigkeitsträger kathodisch geschaltet sind.

4. Verfahren gemäß Anspruch 3, dadurch gekennzeichnet, daß die Spannung etwa 0,1 bis 24 Volt beträgt.

5. Verfahren gemäß Anspruch 1, dadurch gekennzeichnet, daß die chemische undoder galvanische Metallisierung unter Verwendung an sich bekannter Metallisierungsbäder, vorzugsweise chemischer Kupferbäder oder saurer galvanischer Kupferbäder, erfolgt.

6. Verfahren gemäß Ansprüchen 1 bis 5 zur Herstellung metallstrukturierter Folien.

7. Verfahren gemäß Anspruch 6 zur Herstellung kupferstrukturierter Polyimidfolien.

8. Vorrichtung zur Durchführung der Verfahren gemäß Ansprüchen 1 bis 7.

FIGUR

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A- 977 587 (SAINT MARTIN) --- | | C 23 C 18/16 |
| A | FR-A-1 411 996 (BASF) --- | | C 25 D 5/02 |
| A | DE-A-1 521 152 (BASF) ----- | | C 25 F 3/14 |

**RECHERCHIERTE SACHGEBIETE (Int. Cl.5)**

C 23 C
C 25 D
C 25 F
H 05 K
H 01 G

**Der vorliegende Recherchenbericht wurde für alle Patentansprüche erstellt**

| Recherchenort | Abschlußdatum der Recherche | Prüfer |
|---|---|---|
| DEN HAAG | 24-01-1990 | NGUYEN THE NGHIEP |